# EUROPÄISCHE PATENTSCHRIFT

(11) **EP 4 396 592 B1**
(45) Veröffentlichungstag und Bekanntmachung des Hinweises auf die Patenterteilung: **05.11.2025**
(21) Anmeldenummer: 22741761.5
(22) Anmeldetag: 11.07.2022
(51) Int. Cl.: G01R 29/26, H01M 8/04537, H01M 8/04664, B60L 58/30, B60L 3/00, B60L 3/12, H01M 8/04992

(54) **VERFAHREN ZUM VERHINDERN EINER SCHÄDIGUNG EINES BRENNSTOFFZELLENSTAPELS**
METHOD FOR PREVENTING DAMAGE TO A FUEL CELL STACK
PROCÉDÉ DE PRÉVENTION DE DOMMAGES À UN EMPILEMENT DE CELLULES

(30) Priorität: 03.09.2021 DE 102021209686
(43) Veröffentlichungstag der Anmeldung: 10.07.2024
(73) Patentinhaber: Robert Bosch GmbH, 70442 Stuttgart (DE)
(72) Erfinder: BRENK, Achim, 75236 Kaempfelbach (DE); SCHURR, Joachim, 73107 Eschenbach (DE); WIPPLINGER, Kai, 73257 Koengen (DE); WUERZBACH, Thomas, 71732 Tamm (DE); BECKER, Bernd, 70567 Stuttgart (DE)
(86) Internationale Anmeldenummer: PCT/EP2022/069266
(87) Internationale Veröffentlichungsnummer: WO 2023/030729

(56) Entgegenhaltungen:
- EP-B1- 3 207 389
- US-A1- 2017 170 502
- US-A1- 2021 135 258

## Beschreibung

Die Erfindung betrifft ein Verfahren zum Detektieren einer schädigenden Zellspannung eines Zellbereichs eines Brennstoffzellenstapels. Ferner betrifft die Erfindung eine Zellenüberwachung, einen Brennstoffzellenstapel, ein Brennstoffzellenaggregat und ein Brennstoffzellensystem insbesondere für ein Brennstoffzellenfahrzeug.

### Stand der Technik

In einer Niedertemperatur-Polymerelektrolyt-Brennstoffzelle eines Brennstoffzellenaggregats z. B. eines Brennstoffzellensystems bspw. eines Brennstoffzellenfahrzeugs erfolgt eine elektrochemische Wandlung zweier Reaktanten zweier Betriebsmedien in elektrische Energie und Wärme. Hierbei umfasst die Brennstoffzelle zumindest eine Membran-Elektroden-Einheit (MEA: Membrane Electrode Assembly). In der Regel ist die Brennstoffzelle mit einer Vielzahl von in einem Stapel angeordneter Membran-Elektroden-Einheiten und dazwischen angeordneter Bipolarplatten ausgebildet (Brennstoffzellenstapel bzw. Stack).

Zur Überwachung, Steuerung und/oder Regelung eines Brennstoffzellenstapels ist es von Vorteil nicht nur die Parameter des gesamten Brennstoffzellenstapels zu kennen, sondern auch wenigstens einen einer jeder einzelnen Brennstoffzelle (Einzelzelle) innerhalb des Brennstoffzellenstapels. Hierfür kommen sogenannte CVM-Systeme (Zellenüberwachungen, CVM: Cell Voltage Monitor(ing)) zum Einsatz. Da bereits geringste Schädigungen in einer Einzelzelle mit einer exponentiellen Geschwindigkeit in ihren Ausmaßen anwachsen können, ist es von großer Wichtigkeit, eine Fehlfunktion einer betroffenen Einzelzelle frühzeitig zu erkennen, um einer weiteren Schädigung dieser Einzelzelle entgegenwirken zu können.

Aus der US 2021/135258 A1 ist eine Vorrichtung zum Messen der Spannung einer Brennstoffzelle bekannt und aus US 2017/170502 A1 und EP 3 207 389 B1 jeweils ein Verfahren zur Diagnose des Zustands einer Brennstoffzelle.

### Aufgabenstellung

Es ist eine Aufgabe der Erfindung, ein Verfahren zum Zellenüberwachen eines Brennstoffzellenstapels anzugeben. Durch das Zellenüberwachverfahren soll ein frühzeitiges Erkennen einer bevorstehenden Schädigung eines Zellabschnitts des Brennstoffzellenstapels, also einer Einzelzelle und/oder einer Zellengruppe möglich sein.

### Offenbarung der Erfindung

Die Aufgabe der Erfindung ist durch ein Verfahren zum Detektieren einer schädigenden Zellspannung wenigstens eines Zellbereichs eines Brennstoffzellenstapels; sowie mittels einer Zellenüberwachung, einem Brennstoffzellenstapel, einem Brennstoffzellenaggregat oder einem Brennstoffzellensystem insbesondere für ein Brennstoffzellenfahrzeug gelöst. Vorteilhafte Weiterbildungen, zusätzliche Merkmale und/oder Vorteile der Erfindung ergeben sich aus den abhängigen Ansprüchen und der folgenden Beschreibung.

Bei dem erfindungsgemäßen Verfahren wird mittels einer dem Brennstoffzellenstapel individuell zugehörigen Zellenüberwachung, zum Detektieren der schädigenden Zellspannung ein Rauschen eines Signals der Zellspannung ermittelt, wobei eine Veränderung, insbesondere eine Verringerung, des Rauschens gegenüber einem charakteristischen Rauschen der Zellspannung als ein Nutzsignal für eine schädigende Zellspannung detektiert wird. Ein Zellbereich umfasst dabei 1 bis n Einzelzellen; also eine einzige Einzelzelle, eine Zellgruppe, einen Zellverbund etc.

Eine Zellgruppe oder ein Zellverbund umfasst jeweils eine Mehrzahl von Einzelzellen. Die Einzelzellen einer Zellgruppe sind dabei als ein kleiner Stapel im Brennstoffzellenstapel ausgebildet, wobei in diesem kleinen Stapel eine Einzelzelle direkt auf eine andere Einzelzelle folgt. Bei einem Zellverbund hingegen gibt es wenigstens eine Einzelzelle, die zu einer anderen unmittelbar benachbarten Einzelzelle dieses Zellverbunds nicht direkt benachbart ist (es liegt wenigstens eine Einzelzelle dazwischen, die nicht diesem Zellverbund angehört). Bei Zellverbünden ist es z. B. möglich, dass eine Einzelzelle einer Mehrzahl von Zellverbünden zugehörig sein kann. Ferner kann bei einem Zellverbund wenigstens eine Einzelzelle ausgelassen sein, analog zu Zellgruppen untereinander, die zusammen ebenfalls nicht den gesamten Brennstoffzellenstapel konstituieren müssen.

Beim Ermitteln des Rauschens ist es möglich, die Zellspannung selbst für dieses Verfahren nicht zu ermitteln. Alternativ kann mittels der individuellen Zellenüberwachung ferner die Zellspannung des wenigstens einen Zellbereichs für dieses Verfahren ermittelt, insbesondere gemessen, werden. Das charakteristische (Vergleichs-)Rauschen kann ein zeitlich vorab oder aktuell ermitteltes, typisches Rauschen dieses oder wenigstens eines vergleichbaren Brennstoffzellenstapels sein. Dieses typische Rauschen kann unabhängig oder abhängig von einer Höhe der Zellspannung zeitlich vorab empirisch ermittelt werden.

Das charakteristische (Vergleichs-)Rauschen kann bei einem ungestörten Auftreten durch relative Maxima und Minima bezüglich des Signals der Zellspannung gekennzeichnet sein. Das ungestörte Auftreten des charakteristischen Rauschens soll natürlich bedeuten, dass das Rauschen nicht z. B. aufgrund einer einseitigen Spannungsversorgung abgeschnitten wird. Das heißt zum Beispiel, dass das charakteristische Rauschen bei hinreichend großen positiven Zellspannungen ermittelt werden kann. Insbesondere kann dieses Verhältnis 1:1 sein, d. h. Ausschläge des Signals nach oben und Ausschläge des Signals nach unten halten sich die Waage. Andere Verhältnisse sind natürlich ebenfalls möglich, d. h das charakteristische (Vergleichs-)Rauschen kann bei ungestörtem Auftreten durch ein Verhältnis um das Signal der Zellspannung herum gekennzeichnet sein.

Ein gleichbleibendes, insbesondere charakteristisches, Rauschen des Signals der Zellspannung kann ein Zeichen für einen korrekten Betriebszustand des Zellbereichs sein. D. h. eine Zellspannung mit einem gleichbleibenden Rauschen wird gemäß dieses Verfahrens als eine nicht schädigende Zellspannung detektiert. Eine Verringerung des Rauschens des Signals der Zellspannung kann ein Zeichen für eine abfallende Zellspannung sein. D. h. eine Zellspannung mit einem sich verringernden Rauschen wird gemäß dieses Verfahrens derart detektiert, dass bei einem sich weiter verringernden Rauschen der Zellspannung eine potenziell schädigende Zellspannung auftreten kann bzw. wird.

Eine Vergrößerung des Rauschens des Signals der Zellspannung kann ein Zeichen für eine ansteigende Zellspannung sein. D. h. eine Zellspannung mit einem sich vergrößernden Rauschen wird gemäß dieses Verfahrens derart detektiert, dass bei einem sich weiter vergrößernden Rauschen der Zellspannung keine potenziell schädigende Zellspannung mehr auftreten kann bzw. wird. Bleibt ein verändertes, insbesondere charakteristisches, Rauschen im Wesentlichen gleich, muss genau beobachtet werden, in welche Richtung (Verringerung, Gleichbleiben oder Vergrößerung) sich das Rauschen in der Zeit entwickelt.

Die Veränderung (Verringerung, Vergrößerung) des Rauschens kann durch eine signifikante Veränderung einer Spreizung und/oder einer Normalverteilung des Rauschens über der Zellspannung detektiert werden. Dies kann ferner durch ein Auftreten von Zellspannungen von Null bzw. neutralen Zellspannungen detektiert werden. Dies kann weiterhin durch ein Verhältnis zeitlicher Anteile der Zellspannungen größer Null bzw. der neutralen Zellspannung, und von Null bzw. der neutralen Zellspannung detektiert werden. D. h. jeweils natürlich auch, dass das charakteristische Rauschen der Zellspannung hier nicht mehr auftritt.

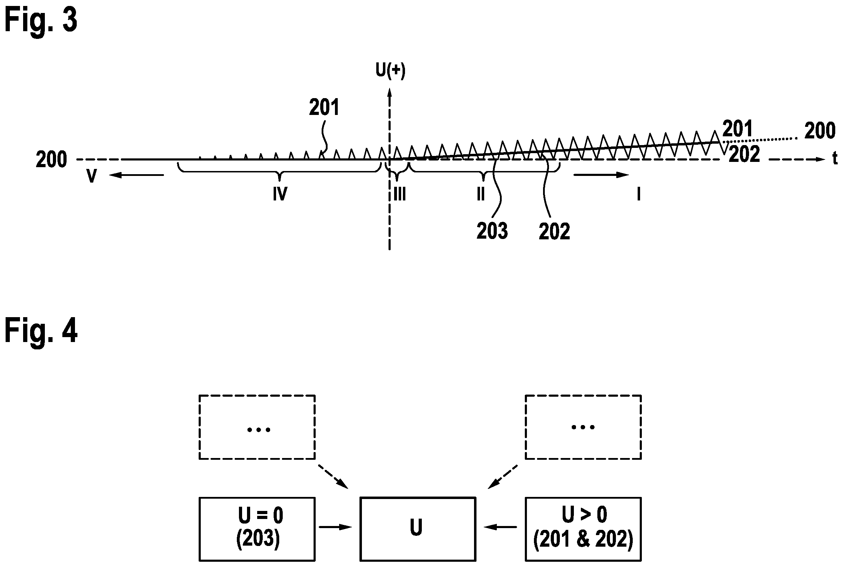

Die nachfolgend angegebenen relativen Stärken, Ausprägungen, Veränderungen etc. des Rauschens des Signals der Zellspannung sind natürlich aufeinander bezogen und konstituieren sich gegenseitig. Hierbei bedeutet ein in seinem Wesen verändertes Rauschen ein Rauschen derart, dass dieses ausgehend vom Signal der Zellspannung im Wesentlichen nunmehr noch in eine Richtung zeigt, also entweder in die einer geringeren oder insbesondere in die einer größeren Zellspannung (vgl. Fig. 3 Bereich III und IV). D. h. ferner, dass ca. die Hälfte des Rauschens abgeschnitten ist.

Ein Ermitteln (vgl. Fig. 3 Bereich II) einer für den Zellbereich problematischen Zellspannung oder eine Annäherung an eine neutrale Zellspannung einer Einzelzelle, kann durch ein geringfügig oder signifikant verändertes, insbesondere ein geringfügig bis signifikant verringertes, Rauschen detektiert werden. Hierbei kann ein verringertes Rauschen in einem Bereich unterhalb (in Richtung kleinerer bzw. weniger positiver Zellspannungen) als im selben Bereich oberhalb (in Richtung größerer bzw. positiverer Zellspannungen) des Signals der Zellspannung detektiert werden. Ferner kann ein vollständig ausgeprägtes charakteristisches Rauschen in einem Bereich oberhalb des Signals der Zellspannung detektiert werden. Das heißt zum Beispiel, dass die Spitzen des Rauschens unterhalb des Signals der Zellspannung teilweise abgeschnitten sind, wobei die Spitzen des Rauschens oberhalb des Signals der Zellspannung unvermindert anwesend sind.

Ein Ermitteln (vgl. Fig. 3 Bereich III) einer für den Zellbereich ggf. schädigenden Zellspannung oder einer neutralen Zellspannung einer Einzelzelle im Zellbereich kann, durch ein signifikant verändertes oder in seinem Wesen verändertes, und insbesondere signifikant verringertes, Rauschen detektiert werden. Hierbei kann bevorzugt kaum ein oder kein Rauschen in einem Bereich unterhalb (in Richtung kleinerer bzw. weniger positiver Zellspannungen) des Signals der Zellspannung detektiert werden. Ferner kann ein vollständig ausgeprägtes oder geringfügig verringertes charakteristisches Rauschen in einem Bereich oberhalb (in Richtung größerer bzw. positiverer Zellspannungen) des Signals der Zellspannung detektiert werden. Das heißt zum Beispiel, dass die Spitzen des Rauschens unterhalb des Signals der Zellspannung fast vollständig bis vollständig abgeschnitten sind, wobei die Spitzen des Rauschens oberhalb des Signals der Zellspannung unvermindert anwesend sind.

Ein Ermitteln (vgl. Fig. 3 Bereich IV) einer für den Zellbereich schädigenden Zellspannung oder einer invertierten Zellspannung einer Einzelzelle im Zellbereich, kann durch ein vollständig in seinem Wesen verändertes und insbesondere stark verringertes Rauschen detektiert werden. Hierbei kann kein Rauschen in einem Bereich unterhalb (in Richtung kleinerer bzw. weniger positiver Zellspannungen) des Signals der Zellspannung detektiert werden. Ferner kann ein geringfügig oder signifikant verringertes charakteristisches Rauschen in einem Bereich oberhalb (in Richtung größerer bzw. positiverer Zellspannungen) des Signals der Zellspannung detektiert werden. Darüber hinaus kann kaum oder bevorzugt kein Rauschen in einem Bereich unterhalb des Signals der Zellspannung detektiert werden. Das heißt zum Beispiel, dass die Spitzen des Rauschens unterhalb des Signals der Zellspannung vollständig abgeschnitten sind, wobei die Spitzen des Rauschens oberhalb des Signals vollständig über vermindert bis fast gar nicht mehr anwesend sind.

Die Zellspannung des Zellbereichs kann durch ein Verhältnis der zeitlichen Anteile von positiven Zellspannungen gegenüber den gleichzeitlichen Anteilen von neutralen Zellspannungen berechnet werden. Ist hier das Verhältnis z. B. 50:50, so liegt die neutrale Zellspannung vor, d. h. der betreffende Zellbereich fügt dem Brennstoffzellenstapel eine Zellspannung von 0V hinzu. Treten zu mehr als 50 % Zellspannungen von größer als Null auf (der Anteil der Zellspannungen von Null ist also kleiner als 50 %), so handelt es sich um eine positive Zellspannung. Treten zu weniger als 50% Zellspannungen von größer als Null auf (der Anteil der Zellspannungen von Null ist also größer als 50%), so handelt es sich um eine negative Zell Spannung.

Mittels der Zellenüberwachung kann eine aktuelle Zellspannung des wenigstens einen Zellbereichs bestimmt werden, wobei zum Detektieren der schädigenden Zellspannung ein Rauschen dieser aktuellen Zellspannung ermittelt wird. D. h. das Verfahren ist als ein Verfahren zum Detektieren einer im Wesentlichen aktuell schädigenden Zellspannung wenigstens eines Zellbereichs des Brennstoffzellenstapels ausgebildet. Ferner kann alternativ oder zusätzlich mittels der Zellenüberwachung durch eine Abtastfrequenz in einem Abtastintervall eine gemittelte Zellspannung des wenigstens einen Zellbereichs bestimmt werden, wobei zum Detektieren der schädigenden gemittelten Zellspannung ein Rauschen der gemittelten Zellspannung im Abtastintervall ermittelt wird. D. h. das Verfahren ist als ein Verfahren zum Detektieren eines schädigenden Niveaus der Zellspannung wenigstens eines Zellbereichs des Brennstoffzellenstapels ausgebildet.

Zum Detektieren der schädigenden Zellspannung kann das Rauschen der aktuellen oder der gemittelten Zellspannung mit wenigstens einem zeitlich vorhergehend ermittelten Rauschen einer aktuellen oder gemittelten Zellspannung verglichen werden. In das Verfahren können ferner empirische Daten wenigstens eines vergleichbaren Brennstoffzellenstapels aus Versuchen, insbesondere auf Prüfständen, einbezogen werden. Des Weiteren können in das Verfahren empirische Daten einer Vielzahl von vergleichbaren Brennstoffzellenstapeln aus deren Betrieb (hierzu zählen ggf. auch die Konditionierungsphasen der Brennstoffzellenstapel) einbezogen werden. Darüber hinaus können in das Verfahren empirische Daten dieses Brennstoffzellenstapels aus seinem Betrieb einbezogen werden.

Die Zellenüberwachung kann eine lediglich einseitige Spannungsversorgung aufweisen/umfassen, welche zum Messen der Zellspannungen eine lediglich positive Spannung zur Verfügung stellt. Die Zellenüberwachung kann keine Spannungsversorgung aufweisen/umfassen, welche zum Messen der Zellspannungen eine negative Spannung zur Verfügung stellen könnte. D. h. die Spannungsversorgung der Zellenüberwachung ist nicht als eine symmetrische Spannungsversorgung ausgebildet, welche die Zellenüberwachung mit positiven und negativen Spannungen versorgen könnte. Zum Messen der Zellspannungen durch die Zellenüberwachung kann ihren Mikroprozessoren eine neutrale Spannung zur Verfügung gestellt werden.

### Kurzbeschreibung der Figuren

Die Erfindung ist im Folgenden anhand von Ausführungsbeispielen unter Bezugnahme auf die beigefügte schematische und nicht maßstabsgetreue Zeichnung näher erläutert. Bei der Erfindung kann ein Merkmal positiv, d. h. vorhanden, oder negativ, d. h. abwesend, ausgestaltet sein. In dieser Spezifikation ist ein negatives Merkmal als Merkmal nicht explizit erläutert, wenn nicht gemäß der Erfindung Wert daraufgelegt ist, dass es abwesend ist. D. h. die tatsächlich gemachte und nicht eine durch den Stand der Technik konstruierte Erfindung darin besteht, dieses Merkmal wegzulassen. Das Fehlen eines Merkmals (negatives Merkmal) in einem Ausführungsbeispiel zeigt, dass das Merkmal optional ist. In den lediglich beispielhaften Figuren (Fig.) der Zeichnung zeigen:
Die Fig. 1 eine schematische Übersichtsdarstellung einer Einrichtung zur Überwachung von Zellspannungen inkl. einer eigentlichen Zellenüberwachung eines Brennstoffzellenstapels eines Brennstoffzellenaggregats,
die Fig. 2 einen Vergleich zweier von der Zellenüberwachung gemessenen Spannungsverläufe einer beliebigen Einzelzelle des Brennstoffzellenstapels, mit einer symmetrischen (oben) und einer einseitigen (unten) Spannungsversorgung der Zellenüberwachung,
die Fig. 3 in einer zur Fig. 2 unten analogen, jedoch stark idealisierten und vergrößerten Darstellung, ein Diagramm eines verrauschten Spannungsverlaufs einer beliebigen Einzelzelle eines Brennstoffzellenstapels um eine neutrale Spannung der Einzelzelle herum, und
die Fig. 4 eine Darstellung zur Verdeutlichung von Ausführungsformen eines erfindungsgemäßen Verfahrens zum Detektieren einer schädigenden Zellspannung wenigstens eines Zellbereichs eines Brennstoffzellenstapels.

### Ausführungsformen der Erfindung

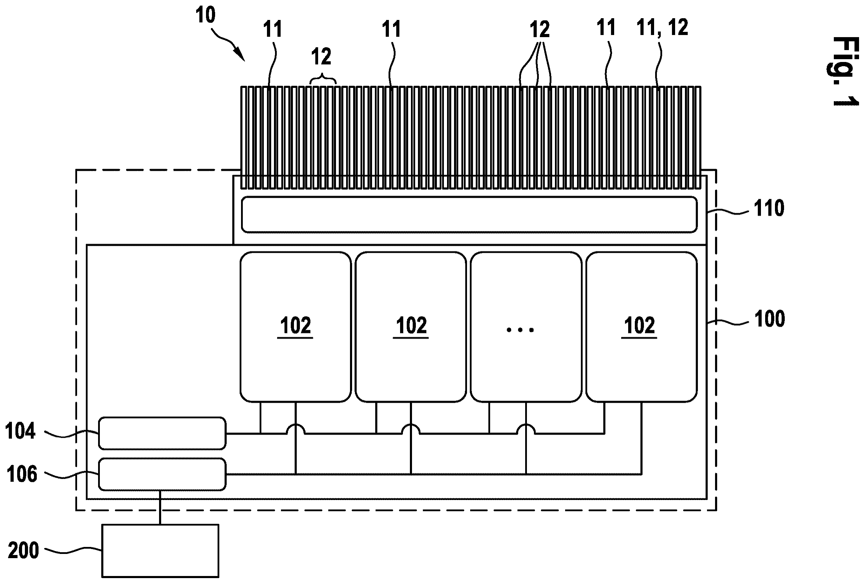

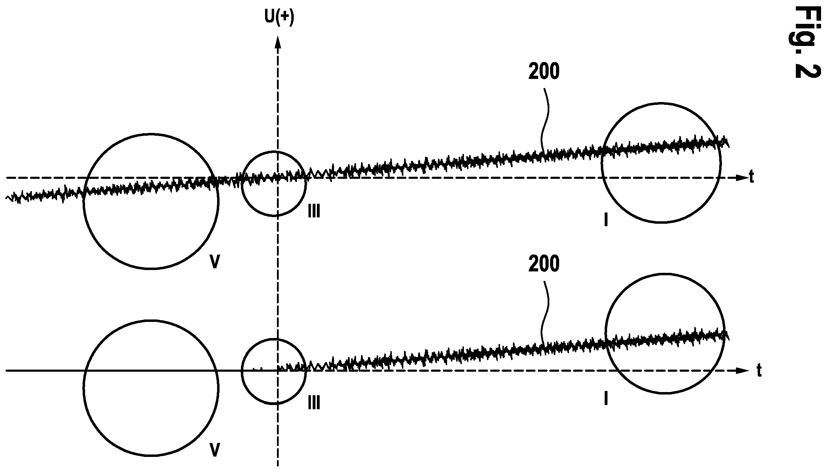

Die Erfindung ist anhand von Ausführungsformen eines Verfahrens zum Detektieren einer schädigenden Zellspannung U (s. Fig. 2 bis 4) wenigstens eines Zellbereichs 12 (vgl. oben) eines Brennstoffzellenstapels 10 (s. Fig. 1) eines Brennstoffzellenaggregats für ein Niedertemperatur-Polymerelektrolyt-Brennstoffzellensystem eines Brennstoffzellenfahrzeugs, d. h. eines Kraftfahrzeugs aufweisend diese Brennstoffzelle bzw. dieses Brennstoffzellensystem, näher erläutert. Obwohl die Erfindung im Detail durch bevorzugte Ausführungsformen näher beschrieben und illustriert ist, so ist die Erfindung nicht durch die offenbarten Ausführungsbeispiele eingeschränkt. Andere Variationen können hieraus abgeleitet werden ohne den Schutzumfang der Erfindung zu verlassen.

Ein Brennstoffzellenstapel 10 (Fig. 1) besteht aus vielen Einzelzellen 11, welche zu einem größeren Verbund elektrisch in Reihe geschaltet sind. Zur Konditionierung, Überwachung, Steuerung und/oder Regelung etc. des Brennstoffzellenstapels 10 und dessen Brennstoffzellensystems ist es von Vorteil, nicht nur Betriebsparameter des gesamten Brennstoffzellenstapels 10 zu kennen, sondern auch Betriebsparameter jedes Zellbereichs 12 und/oder einer jeden Einzelzelle 11 innerhalb des Brennstoffzellenstapels 10. Hierfür kommt eine Zellenüberwachung 100 (CVM) zum Einsatz, welche einer Messung der elektrischen Zellspannungen U und/oder anderer Betriebsparameter der Zellbereiche 12 und/oder der Einzelzellen 11 innerhalb des Brennstoffzellenstapels 10 dient.

Die folgenden Ausführungen betreffen nur noch Einzelzellen 11 des Brennstoffzellenstapels 10, sind aber natürlich auch auf Zellbereiche 12 (vgl. o.) mit einer Mehrzahl von Einzelzellen 11 anwendbar. Gemäß der Erfindung kann dabei ein vorab empirisch ermitteltes und/oder ein aktuelles Verhalten eines solchen Zellbereichs 12 natürlich ggf. in einen Gegenstand der Erfindung miteinbezogen werden.

In einem Normalbetrieb des Brennstoffzellenstapels 10 treten innerhalb einer jeden Einzelzelle 11 (Zellbereiche 12) ausschließlich positive Zellspannungen U auf. Kommt es zu Problemen z. B. bei einer Versorgung des Brennstoffzellenstapels 10 mit Brennstoff, so kann innerhalb einer Einzelzelle 11 auch eine negative Zellspannung U auftreten. Negative Zellspannungen U führen innerhalb kürzester Zeit zu einer Schädigung einer lonenaustauschmembran einer betreffenden Einzelzelle 11 zwischen zwei Bipolarplatten des Brennstoffzellenstapels 10, und damit zu einer rapiden Verkürzung der Lebensdauer der Einzelzelle 11 und in der Folge auch des Brennstoffzellenstapels 10.

Aus diesem Grund ist es erforderlich, die Zellspannungen U des Brennstoffzellenstapels 10 zu erfassen, um frühzeitig auf sich abzeichnende Probleme reagieren zu können. Sobald eine Zellspannung U einer Einzelzelle 11 einen vordefinierten, noch positiven Wert unterschreitet, können bereits erste Maßnahmen eingeleitet werden, welche ein Spannungsniveau der betreffenden Einzelzelle 11 wieder stabilisiert und/oder anhebt. Wenn die Zellspannung U trotz dieser Maßnahmen weiter abfällt und unter eine neutrale Zellspannung U in ihrer Position im Brennstoffzellenstapel 10 abfällt, dann wird eine Sicherheits- bzw. Notabschaltung der betreffenden Einzelzelle 11 bzw. des Brennstoffzellenstapels 10 vorgenommen. Aus diesem Grund ist es erforderlich, dass die Zellenüberwachung 100 auch negative Zellspannungen U messen kann.

Für eine Erfassung und Messung der Zellspannungen U der Einzelzellen 11 können eine Vielzahl von Mikroprozessoren 102 (elektronischer Baustein bzw. Teilarchitektur) eingesetzt werden, welche mehrere Kanäle zur Messung mehrerer Zellspannungen U aufweisen. Ein Nachteil dieser Mikroprozessoren 102 ist eine sogenannte symmetrische Spannungsversorgung, welche für eine Erfassung negativer bzw. invertierter Zellspannungen U erforderlich ist. Um eine negative bzw. invertierte Zellspannung U zu messen, muss ein Mikroprozessor 102 neben einer positiven Spannung U und der neutralen Spannung zudem mit einer negativen Spannung versorgt werden. Wird dieser nicht mit einer negativen Spannung versorgt, so kann die jeweils einem Mikroprozessor 102 zugeordnete unterste bzw. erste Zelle keine negativen bzw. invertierten Zellspannungen erkennen.

Da im Brennstoffzellenfahrzeug keine negative Spannung zur Verfügung steht, ist dies nur mit einer sogenannten symmetrischen Spannungsversorgung und nur mit einem erheblichen Aufwand realisierbar sowie mit hohen Kosten verbunden. Zudem sind die Mikroprozessoren 102, welche zum Messen der negativen bzw. invertierten Zellspannungen U eingesetzt werden, ebenfalls mit Mehrkosten gegenüber herkömmlichen Spannungsmesschips verbunden.

Das Messen der Zellspannungen U der Einzelzellen 11 (Zellbereiche 12) kann dazu beitragen, dass Probleme von Einzelzellen 11 frühzeitig erkannt und in der Folge auch behoben werden können. Da bereits eine geringste Schädigung einer lonenaustauschmembran mit einer exponentiellen Geschwindigkeit in ihrem Ausmaß anwächst, ist es von großer Wichtigkeit, eine Fehlfunktion einer Einzelzelle 11 frühzeitig zu erkennen und etwas dagegen zu unternehmen. Solch eine Schädigung wird durch negative bzw. invertierte Zellspannungen U verursacht. Da das Erfassen und Erkennen solcher Zellspannungen U mit herkömmlichen Methoden kostenintensiv ist, wird ein Verfahren beschrieben, welches lediglich mit Hilfe einer einseitigen Spannungsmessung ebenfalls in der Lage ist, negative bzw. invertierte Zellspannungen zu detektieren und ggf. auch zu messen.

Zum Erkennen von Problemen bzw. einer Vermeidung von Schädigungen der Einzelzellen 11 ist es gemäß der Erfindung ausreichend, lediglich positive Zellspannungen U zu messen. Damit kann eine deutlich kostengünstigere Auswerteschaltung zur Messung der Zellspannungen U realisiert werden. Bei Auftreten negativer bzw. invertierter Zellspannungen U kann ein Spannungswert nun nicht mehr gemessen, aber berechnet werden. Hierzu wird ein Verfahren zur Auswertung der ausschließlich positiven Spannungsmesswerte vorgestellt, welches in der Lage ist, nur aus einem Rauschen 201, 202 der gemessenen Signale 200 (vgl. Fig. 2 und 3) Zellspannungen U und ohne die Messung der negativen bzw. invertierten Zellspannungen U, eindeutige Rückschlüsse auf das Vorzeichen der Zellspannungen U zu erhalten. D. h. es kann eine lediglich einseitige Spannungsversorgung zur Anwendung kommen. Nichtsdestotrotz ist aber auch eine symmetrische Spannungsversorgung anwendbar.

Der Brennstoffzellenstapel 10 (Fig. 1) weist eine Vielzahl von Einzelzellen 11 auf, die zwischen Bipolarplatten des Brennstoffzellenstapels 10 angerichtet sind. Die Zellenüberwachung 100 ist über eine Kontaktierungseinheit 110 (CVP: Cell Voltage Pickup CVP, elektromechanische Spannungsabgreifer inkl. einer jeweiligen Kommunikationsverbindung (Kabel und Steckverbinder)) mit den Bipolarplatten elektrisch verbunden und misst die Zellspannungen U der Einzelzellen 11 bzw. analog dazu der Zellbereiche 12.

Bei Brennstoffzellenstapeln 10 sind Spannungseinbrüche bis hin zu invertierten Spannungsverhältnissen zu beobachten. Eine Ursache kann eine ungleichmäßige Verteilung einer Temperatur oder eine ungleichmäßige Verteilung anderer Parameter bzw. Randbedingungen sein. So kann z. B. eine mangelnde Versorgung mit einem entsprechenden Brennstoff, eine Überversorgung mit einem nicht mehr benötigten Gas und/oder Wasserdampf in einer Einzelzelle 11 dazu führen, dass die Zellspannung U dieser Einzelzelle 11 außerhalb, insbesondere unterhalb, ihres Sollbereichs liegt.

Um über eine Betriebsstrategie derartige Zustände zu erkennen und Gegenmaßnahmen einleiten zu können, ist die Messung der Zellspannungen U erforderlich sowie eine Erkennung von negativen bzw. invertierten Zellspannungen. Dies lässt sich mit Messmitteln z. B. an einem Prüfstand sehr gut darstellen, da hier eine symmetrische Messung der Zellspannung U möglich ist. Hier lassen sich auch typische Werte von Einzelzellen 11 von Brennstoffzellenstapeln 10 und vorliegend auch ein charakteristisches Rauschen 201, 202 einer Zellspannung U einer Einzelzelle 11 eines Brennstoffzellenstapels 10 vorab individuell oder typenspezifisch gewinnen. Dies kann über eine vergleichsweise große Spanne hinweg, also von hohen positiven bis hin zu vergleichsweise hohen negativen Werten erfolgen.

Für einen Betrieb eines Brennstoffzellenstapels 10 in einer Serienanwendung, ist dies aus Platz- und/oder Kostengründen oft nicht möglich. Um trotzdem ein Potenzial einer Betriebsstrategie und/oder einer Diagnose auszuschöpfen, soll die hier beschriebene Zellenüberwachung 100 nur einseitige Zellspannungen U ab Null aufwärts messen können. Zellspannungen U kleiner Null bzw. invertierte Zellspannungen U können nicht gemessen werden, können aber dennoch mittels des nachfolgend beschriebenen Auswerteverfahrens detektiert und ggf. berechnet werden. Wird eine Zellspannung U des Brennstoffzellenstapels 10 nahe der neutralen Spannung bzw. exakt der neutralen Spannung gemessen, kann diese gemessene Zellspannung U von einer negativen Zellspannung U an einer Struktur eines Pegels des Rauschens 201, 202 unterschieden werden, s. Fig. 2 und 3.

D. h. gemäß der Erfindung wird aus dem Rauschen 201, 202 eines Signals 200 der Zellspannung U ein Nutzsignal generiert. Das Rauschen 201, 202 des Signals 200 ist nicht mehr ausschließlich eine Störgröße, sondern ermöglicht gemäß der Erfindung einen kurzen Blick in die Zukunft einer wahrscheinlichen Entwicklung einer Zellspannung U einer Einzelzelle 11 eines Brennstoffzellenstapels 10. Und dies insbesondere in Richtung der für die Einzelzelle 11 problematischen neutralen Spannung und auch in Richtung eines hoch problematischen invertierten Spannungsverhältnisses.

Das obere Diagramm in der Fig. 2 zeigt eine Spannungsmessung einer zeitlich veränderlichen Zellspannung (symmetrische Spannungsversorgung). Die Signale 200 der Zellspannung U umfassen sowohl einen negativen Spannungsbereich (jeweils unterhalb der t-Achse) als auch einen positiven Spannungsbereich (jeweils oberhalb der t-Achse) und sind von einem Rauschen 201, 202 (vgl. auch Fig. 3) überlagert. Dies repräsentiert eine Spannungsmessung welche nicht auf einen rein positiven Messbereich beschränkt ist.

Das untere Diagramm in der Fig. 2 repräsentiert eine Spannungsmessung einer einseitigen, d. h unsymmetrischen, Spannungsmessung (einseitige Spannungsversorgung). Negative bzw. invertierte Spannungen U können nicht erfasst werden und werden als Null ausgegeben. Ein Rauschen 201, 202 tritt hier nur in Richtung positiver Spannungen auf (Fig. 3: Pos. 201); ein Rauschen 201, 202 in den negativen Spannungsbereich (Fig. 3: Pos. 202) tritt aufgrund der einseitigen Spannungsversorgung nicht auf. Das Rauschen 201, 202 tritt prinzipbedingt unter Null bzw. der neutralen Spannung nicht auf; d. h. bei einem maximalen Rauschwert nach unten wird dieser bei positiven Spannungen U beginnend, die vom Betrag hier in diesem Bereich liegen (vgl. Fig. 2 unten und Fig. 3), nach unten hin abgeschnitten (vgl. Fig. 3, Bereich II rechts).

Die beiden Bereiche I in der Fig. 2 zeigen gemessene Signale 200 einer Einzelzelle 11 im ausschließlich positiven Bereich der Zellspannungen U, welche von einem Rauschen 201, 202 überlagert sind. Die beiden Bereiche V in der Fig. 2 repräsentieren gemessene Signale 200 einer Einzelzelle 11, welche im eindeutig negativen Bereich der Zellspannungen U liegen. Im oberen Diagramm der Fig. 2 kann eine Elektronik zur Spannungsmessung ein negatives bzw. invertiertes Signal 200 erfassen und messen. Im unteren Diagramm der Fig. 2 wurde eine wesentlich kostengünstigere Elektronik 102, (104,) 106 mit einseitiger Spannungsversorgung 104 eingesetzt, welche ausschließlich positive Spannungswerte erfassen kann, sodass eine ggf. tatsächlich anliegende negative bzw. invertierte Zellspannung U an einer Einzelzelle 11 nicht mehr gemessen werden kann. Stattdessen wird für solche tatsächlichen Werte immer der Messwert des Signals 200 mit Null ausgegeben.

Man kann in der Fig. 2 unten (vgl. auch die idealisierte Fig. 3) gut erkennen, dass im negativen bzw. invertierten Bereich der Spannungen U ein Rauschen 201, 202 des Signals 200 ebenfalls nicht von der Zellenüberwachung 100 erfasst werden kann. Lediglich ein thermisches Rauschen kann noch einen Einfluss haben, dieser ist jedoch derart gering, dass es von der Zellenüberwachung 100 nicht mehr erfasst werden kann. Die beiden Bereiche V der Fig. 2 kennzeichnen die eindeutig negativen Zellspannungen U, die Bereiche I der Fig. 2 die eindeutig positiven Zellspannungen U. Die Bereiche III der Fig. 2 markieren eine Signalerfassung der Zellenüberwachung 100 in einem Übergangsbereich von gemessenen positiven zu negativen Zellspannungen U bzw. vice versa. Hier ist deutlich zu erkennen, dass das Rauschen 201, 202, welches dem Signal 200 der Zellspannung U überlagert ist, nur im positiven Signalbereich erfasst werden kann, d. h. im gemessenen Signal 200 auch auftritt. Während des Übergangs von einer positiven zu einer negativen Zellspannung U nimmt das messtechnisch erfasste Rauschen 201, 202 sukzessive ab.

Kommt man für das Verfahren von der Seite vergleichsweise hoher positiver Zellspannungen U in Richtung der neutralen Zellspannung U (also von rechts in den Fig. 2 und 3), werden zuerst diejenigen Anteile eines Gesamtsignals (Signal 200 der gemessenen Zellspannung U plus Rauschen 201, 202), welche aufgrund des Rauschens 201, 202 in den Bereich negativer Werte der Zellspannungen U fallen (würden), nicht mehr erfasst (Fig. 3: Bereich II). Liegt das Signal 200 der gemessenen Zellspannung U bei (genau oder ca.) Null, so wird nur noch während (genau oder ca.) einer Hälfte der gemessenen Zeit das Rauschen 201 (, 202) erfasst, die anderen Anteile des Gesamtsignals werden mit Null gemessen (Fig. 3: Bereich III). Fällt die Zellspannung U noch weiter ab (Fig. 3: Bereich IV), so werden die zeitlichen Anteile des Rauschens 201 immer geringer und die zeitlichen Anteile, welche mit Null erfasst werden, nehmen kontinuierlich zu (Fig. 3: Bereich IV nach Bereich V).

Liegt ein zu messendes, mit einem Rauschen 201, 202 behaftetes Signal 200 der Zellspannungen U im Bereich um die neutrale Zellspannung U (Fig. 3: Bereich III) herum, so werden bei einer direkten Messung der Zellspannungen U ein Teil der Messwerte nicht korrekt erfasst, da sie unterhalb der neutralen Zellspannung U liegen und damit nicht erfasst werden können. Dennoch ist es möglich, auch in diesem Spannungsbereich (unterhalb der neutralen Zellspannung U d. h. bei negativen bzw. invertierten Zellspannungen) eine Messung der Zellspannungen U vorzunehmen, ohne dass hierfür eine symmetrische Spannungsquelle oder ein Spannungsmesssystem, welche auch für negative, d. h. invertierte, Zellspannungen U geeignet ist, angewendet werden muss.

Werte der Zellspannungen U, welche (genau oder ca.) Null sind, also der neutralen Zellspannung U entsprechen, sind dadurch gekennzeichnet, dass die Zeitanteile, an welchen der Wert Null (s. Fig. 4: 203, kein Rauschen mehr; und vgl. Fig. 3) gemessen wird, und die Zeitanteile, an welchen aufgrund des Rauschens 201 ein Wert oberhalb von Null gemessen wird (s. Fig. 4: 201, Rauschen tritt auf; und vgl. Fig. 3), sich (genau oder ca.) die Waage halten. Bei Werten der Zellspannungen U, welche größer als Null sind, nimmt ein Zeitanteil, an welchen Werte von Null aufgrund der einseitigen Spannungsversorgung erfasst werden ab, wobei Werte der Zellspannungen U oberhalb von Null in einem Vergleich deutlich öfter erfasst werden (Fig. 3: Bereich II). Bei Werten der Zellspannungen U im negativen Bereich überwiegen die zeitlichen Anteile, an denen eine Null erfasst wird, gegenüber den zeitlichen Anteilen mit positiven Spannungswerten (Fig. 3: Bereich IV).

Mit Hilfe eines Verhältnisses, vgl. die Fig. 4, der zeitlichen Anteile der Zellspannungen U oberhalb von Null (Fig. 4 rechts: U > 0, Rauschen 201, 202 tritt auf) und den zeitlichen Anteilen einer Zellspannung U von Null (Fig. 4 links: U = 0, 203; kein Rauschen 201, 202 mehr), kann nun eine Zellspannung U errechnet werden. Damit ist es auch möglich, Zellspannungen U im negativen Spannungsbereich zu messen, ohne dass das Messsystem negative Zellspannungen U erfassen kann. Ferner kann zum Detektieren der schädigenden Zellspannung U ein zeitlich vorhergehend ermitteltes Rauschen 201, 202 miteinbezogen werden, was in der Fig. 4 gestrichelt dargestellt ist.

Die Erweiterung des Messbereichs in einen Bereich der negativen Zellspannungen U wird ggf. mit einer Reduktion einer Abtastfrequenz der Zellenüberwachung 100 erkauft, möchte man vergleichsweise genaue Mittelwerte erhalten. Da sich die genauen Zellspannungen U aus einem zeitlichen Verhältnis der Messwerte ergeben, muss eine Vielzahl von Messwerten ausgewertet werden, um genaue Mittelwerte der Zellspannungen U zu erhalten. Diese Reduktion der Abtastfrequenz ist aber nur in einem engen Bereich um die neutrale Zellspannung U herum ggf. notwendig. Für die restlichen Bereiche der positiven Zellspannungen U kann eine Abtastrate unverändert bleiben. Das bedeutet, dass sämtliche Regler im Normalbetrieb der Brennstoffzelle auf die bisher übliche Performance der Messwerte zugreifen können und nicht von der Reduktion der Abtastrate betroffen sind.

Um einem exponentiellen Anwachsen von Schädigungen in den Einzelzellen 11 eines Brennstoffzellenstapels 10 entgegenzuwirken, ist es wichtig, eine Fehlfunktion einer Einzelzelle 11 sehr früh zu erkennen und so die Schädigung in einem Keim zu verhindern. Aus diesem Grund werden die Messwerte der Einzelzellen 11 bzw. analog dazu von Zellbereichen 12 mit einer hohen Frequenz erfasst. Damit kann sichergestellt werden, dass eine Fehlfunktion frühzeitig erkannt wird. Je nach Anzahl der Einzelzellen 11 bzw. Zellbereichen 12 innerhalb des Brennstoffzellenstapels 10 werden viele Spannungsmesskanäle benötigt. Durch einen Verzicht auf eine negative Zellspannungsmessung der Elektronik 102, (104,) 106 kann auf eine symmetrische und damit auch galvanisch getrennte und in Folge dessen komplexere, symmetrische Spannungsversorgung verzichtet werden.

Obwohl die Zellenüberwachung 100 keine negativen Zellspannungen U messen kann, ist es mit Hilfe des Verfahrens zum Detektieren einer schädigenden Zellspannung U dennoch möglich, negative Zellspannungen U zu erkennen und zu messen (vgl. auch oben). Der Vorteil besteht in einer Kosteneinsparung und einer Bauraumeinsparung, welcher durch ein einfacheres Schaltungsdesign der Elektronik 102, (104,) 106 erreicht wird; d. h. einen Verzicht auf eine galvanisch getrennte und symmetrische Spannungsversorgung der einzelnen Spannungsmesskanäle, sowie durch den Einsatz von kostengünstigen Mikroprozessoren 102 zur Spannungsmessung.

## Patentansprüche

1. Verfahren zum Detektieren einer schädigenden Zellspannung (U) eines Zellbereichs (12) eines Brennstoffzellenstapels (10), wobei
mittels einer dem Brennstoffzellenstapel (10) individuell zugehörigen Zellenüberwachung (100) zum Detektieren der schädigenden Zellspannung (U) ein Rauschen (201, 202) eines Signals (200) der Zellspannung (U) ermittelt wird, **dadurch gekennzeichnet, dass**
eine Veränderung, insbesondere eine Verringerung, des Rauschens (201, 202) gegenüber einem charakteristischen Rauschen (201, 202) der Zellspannung (U) als ein Nutzsignal für eine schädigende Zellspannung (U) detektiert wird.

2. Verfahren gemäß vorhergehendem Anspruch, **dadurch gekennzeichnet, dass**, beim Ermitteln des Rauschens (201, 202) die Zellspannung (U) selbst für dieses Verfahren nicht ermittelt wird, oder
ferner mittels der individuellen Zellenüberwachung (100) die Zellspannung (U) des wenigstens einen Zellbereichs (12) für dieses Verfahren ermittelt, insbesondere gemessen, wird.

3. Verfahren gemäß einem der vorhergehenden Ansprüche, **dadurch gekennzeichnet, dass**:
• ein gleichbleibendes, insbesondere charakteristisches, Rauschen (201, 202) des Signals (200) der Zellspannung (U) ein Zeichen für einen korrekten Betriebszustand des Zellbereichs (12) ist,
• eine Verringerung des Rauschens (201, 202) des Signals (200) der Zellspannung (U) ein Zeichen für eine abfallende Zellspannung (U) ist, und/oder
• eine Vergrößerung des Rauschens (201, 202) des Signals (200) der Zellspannung (U) ein Zeichen für eine ansteigende Zellspannung (U) ist.

4. Verfahren gemäß einem der vorhergehenden Ansprüche, **dadurch gekennzeichnet, dass** die Veränderung des Rauschens (201, 202):
• durch eine signifikante Veränderung einer Spreizung und/oder einer Normalverteilung des Rauschens (201, 202) über der Zellspannung (U),
• durch ein Auftreten von Zellspannungen (U) von Null (U = 0) bzw. neutralen Zellspannungen (U = 0), und/oder
• durch ein Verhältnis zeitlicher Anteile der Zellspannungen (U) größer Null (U > 0) bzw. der neutralen Zellspannung (U > 0), und von Null (U = 0) bzw. der neutralen Zellspannung (U > 0)
detektiert wird.

5. Verfahren gemäß einem der vorhergehenden Ansprüche, **dadurch gekennzeichnet, dass** ein Ermitteln einer für den Zellbereich (12) problematischen Zellspannung (U) oder eine Annäherung an eine neutrale Zellspannung (U) einer Einzelzelle (11) durch (II):
• ein geringfügig oder signifikant verändertes, insbesondere ein geringfügig bis signifikant verringertes, Rauschen (201, 202),
• ein verringertes Rauschen (201, 202) in einem Bereich unterhalb (202) als im selben Bereich oberhalb (201) des Signals (200) der Zellspannung (U), und/oder
• ein vollständig ausgeprägtes charakteristisches Rauschen (201) in einem Bereich oberhalb (201) des Signals (200) der Zellspannung (U)
detektiert wird.

6. Verfahren gemäß einem der vorhergehenden Ansprüche, **dadurch gekennzeichnet, dass** ein Ermitteln einer für den Zellbereich (12) ggf. schädigenden Zellspannung (U) oder einer neutralen Zellspannung (U) einer Einzelzelle (11) im Zellbereich (12) durch (III):
• ein signifikant verändertes oder in seinem Wesen verändertes, und insbesondere signifikant verringertes Rauschen (201, 202),
• bevorzugt kaum ein oder kein Rauschen (201, 202) in einem Bereich unterhalb (202) des Signals (200) der Zellspannung (U), und/oder
• ein vollständig ausgeprägtes oder geringfügig verringertes charakteristisches Rauschen (201) in einem Bereich oberhalb (201) des Signals (200) der Zellspannung (U)
detektiert wird.

7. Verfahren gemäß einem der vorhergehenden Ansprüche, **dadurch gekennzeichnet, dass** ein Ermitteln einer für den Zellbereich (12) schädigenden Zellspannung (U) oder einer invertierten Zellspannung (U) einer Einzelzelle (11) im Zellbereich (12) durch (IV):
• ein vollständig in seinem Wesen verändertes und insbesondere stark verringertes Rauschen (201, 202),
• kein Rauschen (201, 202) in einem Bereich unterhalb (202) des Signals (200) der Zellspannung (U),
• ein geringfügig oder signifikant verringertes charakteristisches Rauschen (201) in einem Bereich oberhalb (201) des Signals (200) der Zellspannung (U), und/oder
• kaum oder bevorzugt kein Rauschen (201) in einem Bereich unterhalb (202) des Signals (200) der Zellspannung (U)
detektiert wird.

8. Verfahren gemäß einem der vorhergehenden Ansprüche, **dadurch gekennzeichnet, dass** die Zellspannung (U) des Zellbereichs (12) durch ein Verhältnis der zeitlichen Anteile von positiven Zellspannungen (U) gegenüber den gleichzeitlichen Anteilen von neutralen Zellspannungen (U) berechnet wird.

9. Verfahren gemäß einem der vorhergehenden Ansprüche, **dadurch gekennzeichnet, dass** mittels der Zellenüberwachung (100) eine aktuelle Zellspannung (U) des wenigstens einen Zellbereichs (12) bestimmt wird, und zum Detektieren der schädigenden Zellspannung (U) ein Rauschen (201, 202) dieser aktuellen Zellspannung (U) ermittelt wird, und/oder
mittels der Zellenüberwachung (100) durch eine Abtastfrequenz in einem Abtastintervall eine gemittelte Zellspannung (U) des wenigstens einen Zellbereichs (12) bestimmt wird, und zum Detektieren der schädigenden gemittelten Zellspannung (U) ein Rauschen (201, 202) der gemittelten Zellspannung (U) im Abtastintervall ermittelt wird.

10. Verfahren gemäß einem der vorhergehenden Ansprüche, **dadurch gekennzeichnet, dass** zum Detektieren der schädigenden Zellspannung (U) das Rauschen (201, 202) der aktuellen oder der gemittelten Zellspannung (U) mit wenigstens einem zeitlich vorhergehend ermittelten Rauschen (201, 202) einer aktuellen oder gemittelten Zellspannung (U) verglichen wird.

11. Verfahren gemäß einem der vorhergehenden Ansprüche, **dadurch gekennzeichnet, dass**:
• die Zellenüberwachung (100) eine lediglich einseitige Spannungsversorgung aufweist/umfasst, welche zum Messen der Zellspannungen (U) eine lediglich positive Spannung zur Verfügung stellt,
• die Zellenüberwachung (100) keine Spannungsversorgung aufweist/umfasst, welche zum Messen der Zellspannungen (U) eine negative Spannung zur Verfügung stellen könnte, und/oder
• zum Messen der Zellspannungen (U) durch die Zellenüberwachung (100) ihren Mikroprozessoren (102) eine neutrale Spannung zur Verfügung gestellt wird.

12. Zellenüberwachung (100), Brennstoffzellenstapel (10), Brennstoffzellenaggregat (1) oder Brennstoffzellensystem insbesondere für ein Brennstoffzellenfahrzeug, **dadurch gekennzeichnet, dass**
durch die Zellenüberwachung, das Brennstoffzellenaggregat (1) oder das Brennstoffzellensystem ein Zellenüberwachverfahren gemäß einem der vorhergehenden Ansprüche durchführbar ist und/oder durchgeführt wird.

## Claims

1. Method for detecting a harmful cell voltage (U) of a cell region (12) of a fuel cell stack (10), wherein a cell monitoring system (100) corresponding individually to the fuel cell stack (10) for detecting the harmful cell voltage (U) is used to ascertain a noise (201, 202) of a signal (200) of the cell voltage (U), **characterized in that** a change, in particular a reduction, in the noise (201, 202) compared to a characteristic noise (201, 202) of the cell voltage (U) is detected as a useful signal for a harmful cell voltage (U).

2. Method according to the preceding claim, **characterized in that**, when ascertaining the noise (201, 202), the cell voltage (U) itself is not ascertained for this method, or the individual cell monitoring system (100) is also used to ascertain, in particular to measure, the cell voltage (U) of at least one cell region (12) for this method.

3. Method according to either one of the preceding claims, **characterized in that**
• consistent, in particular characteristic, noise (201, 202) of the signal (200) of the cell voltage (U) is an indication of a correct operating state of the cell region (12),
• a reduction in the noise (201, 202) of the signal (200) of the cell voltage (U) is an indication of a decreasing cell voltage (U), and/or
• an increase in the noise (201, 202) of the signal (200) of the cell voltage (U) is an indication of an increasing cell voltage (U).

4. Method according to any of the preceding claims, **characterized in that** the change in the noise (201, 202) is detected:
• by a significant change in the spread and/or normal distribution of the noise (201, 202) over the cell voltage (U),
• by the occurrence of cell voltages (U) of zero (U = 0) or neutral cell voltages (U = 0), and/or
• by a ratio of the time components of the cell voltages (U) greater than zero (U > 0) or the neutral cell voltage (U > 0), and of zero (U = 0) or the neutral cell voltage (U > 0).

5. Method according to any one of the preceding claims, **characterized in that** the ascertaining of a cell voltage (U) that is problematic for the cell region (12) or an approximation to a neutral cell voltage (U) of a single cell (11) is detected by (II):
• a slightly or significantly changed noise, in particular a slightly to significantly reduced noise (201, 202),
• a reduced noise (201, 202) in a range below (202) than in the same range above (201) the signal (200) of the cell voltage (U), and/or
• a fully developed characteristic noise (201) in a range above (201) the signal (200) of the cell voltage (U).

6. Method according to any one of the preceding claims, **characterized in that** the ascertaining of a cell voltage (U) that may be harmful for the cell region (12) or a neutral cell voltage (U) of a single cell (11) in the cell region (12) is detected by (III):
• a significantly altered or essentially altered, and in particular significantly reduced, noise (201, 202),
• preferably little or no noise (201, 202) in a range below (202) the signal (200) of the cell voltage (U), and/or
• a fully developed or slightly reduced characteristic noise (201) in a range above (201) the signal (200) of the cell voltage (U).

7. Method according to any one of the preceding claims, **characterized in that** the ascertaining of a cell voltage (U) that is harmful for the cell region (12) or an inverted cell voltage (U) of a single cell (11) in the cell region (12) is detected by (IV):
• a completely essentially altered, and in particular significantly reduced, noise (201, 202),
• no noise (201, 202) in a range below (202) the signal (200) of the cell voltage (U),
• a slightly or significantly reduced characteristic noise (201) in a range above (201) the signal (200) of the cell voltage (U), and/or
• hardly any or preferably no noise (201) in a range below (202) the signal (200) of the cell voltage (U).

8. Method according to any one of the preceding claims, **characterized in that** the cell voltage (U) of the cell region (12) is calculated by a ratio of the time components of positive cell voltages (U) with respect to the simultaneous components of neutral cell voltages (U).

9. Method according to any one of the preceding claims, **characterized in that** the cell monitoring system (100) is used to determine a current cell voltage (U) of the at least one cell region (12) and, in order to detect the harmful cell voltage (U), to determine a noise (201, 202) of this current cell voltage (U), and/or the cell monitoring system (100) uses a sampling frequency in a sampling interval to determine an average cell voltage (U) of the at least one cell region (12) and, in order to detect the harmful average cell voltage (U), to determine a noise (201, 202) of the average cell voltage (U) in the sampling interval.

10. Method according to any one of the preceding claims, **characterized in that**, in order to detect the harmful cell voltage (U), the noise (201, 202) of the current or the average cell voltage (U) is compared with at least one previously determined noise (201, 202) of a current or average cell voltage (U).

11. Method according to either one of the preceding claims, **characterized in that**
• the cell monitoring system (100) has/comprises a voltage supply on one side only, which provides only a positive voltage for measuring the cell voltages (U),
• the cell monitoring system (100) does not have/comprise a voltage supply that could provide a negative voltage for measuring the cell voltages (U), and/or
• a neutral voltage is provided to the microprocessors (102) of the cell monitoring system for measuring the cell voltages (U) by way of said cell monitoring system (100).

12. Cell monitoring system (100), fuel cell stack (10), fuel cell unit (1) or fuel cell system in particular for a fuel cell vehicle, **characterized in that** the cell monitoring system, the fuel cell unit (1) or the fuel cell system can be or is used to carry out a cell monitoring method according to any one of the preceding claims.

## Revendications

1. Procédé pour détecter une tension de cellule (U) dommageable d'une zone de cellule (12) d'un empilement de piles à combustible (10), dans lequel, au moyen d'une surveillance de cellule (100) associée individuellement à l'empilement de piles à combustible (10) et destinée à détecter la tension de cellule (U) dommageable, un bruit (201, 202) d'un signal (200) de la tension de cellule (U) est déterminé, **caractérisé en ce qu'**une modification, en particulier une diminution, du bruit (201, 202) par rapport à un bruit caractéristique (201, 202) de la tension de cellule (U) est détectée sous la forme d'un signal utile pour une tension de cellule (U) dommageable.

2. Procédé selon la revendication précédente, **caractérisé en ce que**, lors de la détermination du bruit (201, 202), la tension de cellule (U) elle-même n'est pas déterminée pour ce procédé, ou
**en ce que** la tension de cellule (U) de l'au moins une zone de cellule (12) est en outre déterminée, en particulier mesurée, pour ce procédé au moyen de la surveillance de cellule individuelle (100).

3. Procédé selon l'une des revendications précédentes, **caractérisé en ce que** :
• un bruit constant, en particulier caractéristique (201, 202), du signal (200) de la tension de cellule (U) est un signe d'un état de fonctionnement correct de la zone de cellule (12),
• une diminution du bruit (201, 202) du signal (200) de la tension de cellule (U) est un signe d'une tension de cellule décroissante (U), et/ou
• une augmentation du bruit (201, 202), du signal (200) de la tension de cellule (U) est un signe d'une tension de cellule (U) croissante.

4. Procédé selon l'une des revendications précédentes, **caractérisé en ce que** la modification du bruit (201, 202) est détectée :
• par une modification significative d'une dispersion et/ou d'une distribution normale du bruit (201, 202) par rapport à la tension de cellule (U),
• par l'apparition d'une tension de cellule (U) nulle (U = 0) ou de tensions de cellule neutres (U = 0), et/ou
• par un rapport des proportions temporelles des tensions de cellule (U) supérieures à zéro (U > 0) et le cas échéant, de la tension de cellule neutre (U > 0), et de zéro (U = 0) et le cas échéant, de la tension de cellule neutre (U > 0).

5. Procédé selon l'une des revendications précédentes, **caractérisé en ce que** la détermination d'une tension de cellule problématique (U) pour la zone de cellule (12) ou d'une tension tendant vers une tension de cellule (U) neutre d'une cellule individuelle (11) est détectée par (II) :
• un bruit (201, 202) faiblement ou significativement modifié, en particulier faiblement à significativement diminué,
• un bruit (201, 202) diminué dans une zone inférieure (202) par rapport à la même zone supérieure (201) du signal (200) de la tension de cellule (U), et/ou
• un bruit caractéristique (201) pleinement prononcé dans une zone supérieure (201) du signal (200) de la tension de cellule (U).

6. Procédé selon l'une des revendications précédentes, **caractérisé en ce que** la détermination d'une tension de cellule (U) dommageable le cas échéant pour la zone de cellule (12) ou d'une tension de cellule (U) neutre d'une cellule individuelle (11) dans la zone de cellule (12) est détectée par (III) :
• un bruit (201, 202) significativement modifié ou modifié dans sa nature, et en particulier significativement diminué,
• de préférence peu ou pas de bruit (201, 202) dans une zone inférieure (202) du signal (200) de la tension de cellule (U), et/ou
• un bruit caractéristique (201) pleinement prononcé ou légèrement diminué dans une zone supérieure (201) du signal (200) de la tension de cellule (U).

7. Procédé selon l'une des revendications précédentes, **caractérisé en ce que** la détermination d'une tension de cellule (U) dommageable pour la zone de cellule (12) ou d'une tension de cellule (U) inversée d'une cellule individuelle (11) dans la zone de cellule (12) est détectée par (IV) :
• un bruit (201, 202) complètement modifié dans sa nature et en particulier fortement diminué,
• aucun bruit (201, 202) dans une zone inférieure (202) du signal (200) de la tension de cellule (U),
• un bruit caractéristique (201) faiblement ou significativement diminué dans une zone supérieure (201) du signal (200) de la tension de cellule (U), et/ou
• peu ou de préférence pas de bruit (201) dans une zone inférieure (202) du signal (200) de la tension de cellule (U).

8. Procédé selon l'une des revendications précédentes, **caractérisé en ce que** la tension de cellule (U) de la zone de cellule (12) est calculée par un rapport des proportions temporelles de tensions de cellule (U) positives par rapport aux proportions simultanées de tensions de cellule (U) neutres.

9. Procédé selon l'une des revendications précédentes, **caractérisé en ce qu'**une tension de cellule (U) actuelle de l'au moins une zone de cellule (12) est déterminée au moyen de la surveillance de cellule (100), et qu'un bruit (201, 202) de cette tension de cellule (U) actuelle est déterminé pour détecter la tension de cellule (U) dommageable, et/ou
**en ce qu'**une tension de cellule (U) moyennée de l'au moins une zone de cellule (12) est déterminée au moyen de la surveillance de cellule (100) par une fréquence d'échantillonnage se situant dans un intervalle d'échantillonnage, et **en ce qu'**un bruit (201, 202) de la tension de cellule (U) moyennée est déterminé dans l'intervalle d'échantillonnage pour détecter la tension de cellule (U) dommageable moyennée.

10. Procédé selon l'une des revendications précédentes, **caractérisé en ce que**, pour détecter la tension de cellule (U) dommageable, le bruit (201, 202) de la tension de cellule (U) actuelle ou moyennée est comparé à au moins un bruit (201, 202) d'une tension de cellule (U) actuelle ou moyennée déterminé antérieurement dans le temps.

11. Procédé selon l'une des revendications précédentes, **caractérisé en ce que** :
• la surveillance de cellule (100) comprend une alimentation en tension d'un seul côté qui met à disposition une tension uniquement positive pour mesurer les tensions de cellule (U),
• la surveillance de cellule (100) ne comprend aucune alimentation en tension qui pourrait mettre à disposition une tension négative pour mesurer les tensions de cellule (U), et/ou
• pour mesurer les tensions de cellule (U) au moyen de la surveillance de cellule (100), une tension neutre est mise à la disposition de ses microprocesseurs (102).

12. Surveillance de cellule (100), empilement de piles à combustible (10), groupe de piles à combustible (1) ou système de piles à combustible, en particulier pour un véhicule à pile à combustible, **caractérisé en ce que**
un procédé de surveillance de cellule selon l'une des revendications précédentes peut être et/ou est mis en œuvre par la surveillance de cellule, le groupe de piles à combustible (1) ou le système de piles à combustible.
